# EUROPEAN PATENT SPECIFICATION

(11) **EP 3 563 414 B1**
(45) Date of publication and mention of the grant of the patent: **24.11.2021**
(21) Application number: 17823236.9
(22) Date of filing: 15.12.2017
(51) Int. Cl.: H01L 27/146

(54) **CAMERA MODULE, METHOD FOR PRODUCING CAMERA MODULE,AND ELECTRONIC APPARATUS**
KAMERAMODUL, VERFAHREN ZUR HERSTELLUNG EINES KAMERAMODULS UND ELEKTRONISCHE VORRICHTUNG
MODULE DE CAMÉRA, PROCÉDÉ DE FABRICATION DE MODULE DE CAMÉRA, ET APPAREIL ÉLECTRONIQUE

(30) Priority: 28.12.2016 JP 2016256829
(43) Date of publication of application: 06.11.2019
(73) Proprietor: Sony Semiconductor Solutions Corporation, Atsugi-shi, Kanagawa 243-0014 (JP)
(72) Inventor: KIMURA Katsuji, Atsugi-shi Kanagawa 243-0014 (JP); SEKI Hirokazu, Kikuchi-gun Kumamoto 869-1102 (JP)
(74) Representative: MFG Patentanwälte Meyer-Wildhagen Meggle-Freund Gerhard PartG mbB
(86) International application number: PCT/JP2017/045041
(87) International publication number: WO 2018/123643

(56) References cited:
- US-A1- 2012 314 126
- US-A1- 2014 043 519
- US-A1- 2015 340 397

## Description

### Technical Field

The present disclosure relates to an imaging device, a method for producing the imaging device, and an electronic apparatus. More particularly, the present disclosure relates to an imaging device with an imaging element less liable to warp and tilt and improving yields, a method for producing the imaging device, and electronic apparatus.

### Background Art

Imaging devices mounted on digital still cameras and camera-bearing mobile terminals are undergoing evolution toward increase in pixel density and reduction in size and thickness. The size and thickness reduction is usually achieved by converting the solid-state imaging element into that of chip size package (CSP) type (see PTL 1, for example).

From US 2012/0314126 A1, a miniaturization image capturing module is known, which includes a substrate unit, an image capturing unit, a fixing glue unit and a lens unit. The substrate unit includes a hollow substrate body, a plurality of top conductive pads, a plurality of bottom conductive pads and a plurality of embedded conductive traces. The hollow substrate body has at least one receiving space and each embedded conductive trace is electrically connected between the at least one of the top conductive padas and at least one of the bottom conductive pads. The image capturing unit includes at least one image capturing chip received in the receiving space and electrically connected to the substrate unit. The fixing glue unit includes a fixing glue disposed in the receiving space and fixed between the hollow substrate body and the image capturing chip. The lens unit is disposed on the top side of the hollow substrate body.

### Citation List

### Patent Literature

PTL 1: PCT Patent Publication No. WO2016/056510

### Summary of Invention

### Technical Problem

The solid-state imaging element of CSP type described in PTL 1, however, has a disadvantage of suffering warp and tilt at the time of mounting, which leads to low yields and poor optical properties.

The present disclosure was completed in view of such situations. To be more specific, it is desirable to maintain yields and optical properties by reducing the warp and tilt which are liable to occur in the solid-state imaging element of CSP type.

### Solution to Problem

According to a first aspect, the present invention provides a camera module in accordance with independent claim 1. According to a second aspect, the present invention provides a method for producing a camera module of the first aspect in accordance with independent claim 14. According to a third aspect, the present invention provides an electronic apparatus in accordance with independent claim 15. Further aspects of the present invention are set forth in the dependent claims, the drawings and the following description.

According to an embodiment of the present disclosure, there is provided an imaging device including a CSP solid-state imaging element having a solid-state imaging element which performs photoelectric conversion to generate electric signals in response to an amount of light received and a glass substrate which fixes the solid-state imaging element, both forming together an integral body, a circuit substrate having a circuit to transfer outward the electrical signals which have undergone photoelectric conversion, and a spacer which fixes the CSP solid-state imaging element and the circuit substrate. The spacer has a fixing section which leads the CSP solid-state imaging element to a prescribed position on the circuit substrate when the CSP solid-state imaging element is mounted.

The circuit substrate mentioned above is formed from a material which has a coefficient of linear expansion close to that of the solid-state imaging element.

The circuit substrate mentioned above is formed from a material which has an elastic modulus smaller than a prescribed value.

The fixing section mentioned above is so designed as to lead two or more sides of a square solid-state imaging element to a prescribed position on the circuit substrate.

The fixing section mentioned above is so designed as to lead four angular corners of a square solid-state imaging element to a prescribed position on the circuit substrate.

The CSP solid-state imaging element mentioned above further includes an infrared cut filter to block infrared rays from the received light, the solid-state imaging element and the glass substrate are bonded together with a clear adhesive, and the glass substrate and the infrared cut filter are bonded together with a clear adhesive.

The CSP solid-state imaging element mentioned above further includes an upper-layer lens which constitutes a part of lens group which converges the received light.

The CSP solid-state imaging element mentioned above further includes a lower-layer lens which is arranged on either or both the infrared cut filter and glass substrate, the lower-layer lens constituting one part which is different from the one part contained in the lens group converging the received light, and which is arranged in front of the solid-state imaging element and in closer proximity to the solid-state imaging element than to the upper-layer lens.

The CSP solid-state imaging element mentioned above further includes an infrared cut filter to block infrared rays from the received light, and the infrared cut filter may be arranged between the glass substrate and the solid-state imaging element.

The CSP solid-state imaging element mentioned above further includes an upper-layer lens of the lens group to converge the received light and a focusing section which converges to a prescribed position the light received by the upper-layer lens.

The focusing section mentioned above includes an actuator which drives the upper-layer lens so that the received light is focused on a prescribed position.

The actuator mentioned above drives the upper-layer lens to produce either or both focusing function and image stabilizing function.

The glass substrate mentioned above functions as an infrared cut filter which scarcely suffers from bending and distortion.

The glass substrate mentioned above is a bluish sheet glass.

The imaging device mentioned above further includes an upper-layer lens including a part of the lens group to converge the received light and an infrared cut filter to block infrared rays from the received light. The infrared cut filter is separate from the CSP solid-state imaging element and is arranged between the upper-layer lens and the solid-state imaging element.

The circuit substrate mentioned above includes a connector or anisotropic conductive film (ACF) terminal to output outward an image signal which is output from the solid-state imaging element.

According to an embodiment of the present disclosure, there is provided a method for producing an imaging device including a CSP solid-state imaging element having a solid-state imaging element which performs photoelectric conversion to generate electric signals in response to an amount of light received and a glass substrate which fixes the solid-state imaging element, both forming together an integral body, a circuit substrate having a circuit to transfer outward the electrical signals which have undergone photoelectric conversion, and a spacer which fixes the CSP solid-state imaging element and the circuit substrate. The spacer has a fixing section which leads the CSP solid-state imaging element to a prescribed position on the circuit substrate when the CSP solid-state imaging element is mounted. The method includes fixing the circuit substrate to the circuit substrate, leading and fitting the CSP solid-state imaging element to a prescribed position on the circuit substrate by means of the fixing section of the spacer and fixing the spacer to the circuit substrate, and injecting a fixing agent into the gap between the solid-state imaging element and the spacer.

According to an embodiment of the present disclosure, there is provided an electronic apparatus including a CSP solid-state imaging element having a solid-state imaging element which performs photoelectric conversion to generate electric signals in response to an amount of light received and a glass substrate which fixes the solid-state imaging element, both forming together an integral body, a circuit substrate having a circuit to transfer outward the electrical signals which have undergone photoelectric conversion, and a spacer which fixes the CSP solid-state imaging element and the circuit substrate. The spacer has a fixing section which leads the CSP solid-state imaging element to a prescribed position on the circuit substrate when the CSP solid-state imaging element is mounted.

According to an embodiment of the present disclosure, a CSP solid-state imaging element is integrally composed of a solid-state imaging element and a glass substrate, the solid-state imaging element performing photoelectric conversion in response to the amount of received light and the solid-state imaging element being fixed by the glass substrate. A circuit substrate has circuits to transfer outward the electric signals resulting from the photoelectric conversion. The CSP solid-state imaging element and the circuit substrate are fixed together by a spacer which leads the CSP solid-state imaging element to a prescribed position on the circuit substrate at the time of its mounting.

Some embodiments relate to a camera module, including: an imaging device, having: a solid-state image sensor, and a glass substrate bonded to a light-incident side of the solid-state image sensor, the solid-state image sensor and the glass substrate together forming an integral body; a circuit substrate electrically coupled to the solid-state image sensor; and a spacer which fixes a position of the imaging device relative to the circuit substrate, in which the spacer has a fixing structure, the fixing structure having a plurality of first surfaces positioned closer to the imaging device than at least one second surface of the spacer, the at least one second surface of the spacer being separated from the imaging device by adhesive.

The imaging device may have a rectangular shape.

The plurality of first surfaces may be positioned adjacent corners and/or sides of the imaging device.

The plurality of first surfaces may be positioned adjacent diagonal corners and/or sides of the imaging device.

The plurality of first surfaces of the spacer may include at least three first surfaces of the spacer.

The at least one second surface of the spacer may include a plurality of second surfaces of the spacer.

The imaging device may further include an upper-layer lens which constitutes a first part of a lens group which converges the received light.

The imaging device may further include a lower-layer lens which is arranged on over the glass substrate, the lower-layer lens constituting a second part which is different from the first part and which is arranged on the light-incident side of the solid-state image sensor and in closer proximity to the solid-state image sensor than to the upper-layer lens.

The camera module may further include an infrared cut filter disposed between the upper-layer lens and the lower-layer lens.

The imaging device may further include an infrared cut filter to block infrared rays from received light. The solid-state image sensor and the glass substrate may be bonded together with a transparent adhesive. The glass substrate and the infrared cut filter may be bonded together with a transparent adhesive.

The imaging device may further include an upper-layer lens which constitutes a first part of a lens group which converges the received light.

The imaging device may further include a lower-layer lens which is arranged on the infrared cut filter, the lower-layer lens constituting a second part which is different from the first part and which is arranged on the light-incident side of the solid-state image sensor and in closer proximity to the solid-state image sensor than to the upper-layer lens.

The imaging device may further include an infrared cut filter to block infrared rays from received light. The infrared cut filter may be arranged between the glass substrate and the solid-state image sensor.

The imaging device may further include an upper-layer lens of a lens group to converge received light and a focusing apparatus which converges to a prescribed position light received by the upper-layer lens.

The focusing apparatus may further include an actuator which drives the upper-layer lens so that the received light is focused on the prescribed position.

The actuator may drive the upper-layer lens to produce either or both of a focusing function and an image stabilizing function.

The glass substrate may function as an infrared cut filter.

The glass substrate may be a bluish sheet glass.

The imaging device may further include a lower-layer lens which is arranged on over the glass substrate.

The imaging device may further include an upper-layer lens which constitutes a first part of a lens group which converges received light. The lower-layer lens may constitute a second part of the lens group.

The camera module may further include an upper-layer lens including a part of a lens group to converge received light; and an infrared cut filter to block infrared rays from the received light. The infrared cut filter may be separate from the imaging device and arranged between the upper-layer lens and the solid-state image sensor.

The circuit substrate may further include a connector or an anisotropic conductive film terminal to output an image signal provided by the solid-state image sensor.

The glass substrate may be bonded to the solid-state image sensor above a photoelectric conversion device of the solid-state image sensor.

The camera module may further include a cavity between the glass substrate and the solid-state image sensor.

The glass substrate may include a frame at its periphery for mounting the glass substrate on the solid-state image sensor with the cavity therebetween.

Some embodiments relate to a method for producing a camera module including an imaging device, having: a solid-state image sensor, and a glass substrate bonded to a light-incident side of the solid-state image sensor, the solid-state image sensor and the glass substrate together forming an integral body; a circuit substrate electrically coupled to the solid-state image sensor; and a spacer which fixes a position of the imaging device relative to the circuit substrate, in which the spacer has a fixing structure, the fixing structure having a plurality of first surfaces positioned closer to the imaging device than at least one second surface of the spacer, the at least one second surface of the spacer being separated from the imaging device by adhesive, the method including: positioning the imaging device at a prescribed position over the circuit substrate using the fixing structure; and injecting a fixing agent into a gap between the imaging device and the at least one second surface of the spacer.

Some embodiments relate to an electronic apparatus including: a camera module, including: an imaging device, having: a solid-state image sensor, and a glass substrate bonded to a light-incident side of the solid-state image sensor, the solid-state image sensor and the glass substrate together forming an integral body; a circuit substrate electrically coupled to the solid-state image sensor; and a spacer which fixes a position of the imaging device relative to the circuit substrate, in which the spacer has a fixing structure, the fixing structure having a plurality of first surfaces positioned closer to the imaging device than at least one second surface of the spacer, the at least one second surface of the spacer being separated from the imaging device by adhesive.

### Advantageous Effects of Invention

One embodiment of the present disclosure disclosed herein makes it possible to reduce warp and tilt, which are easily involved in solid-state imaging element of CSP type, thereby maintaining yields and optical properties.

### Brief Description of Drawings

[fig.1]FIG. 1 is a schematic diagram illustrating the structure of an imaging device according to a first embodiment of the present disclosure.
[fig.2]FIG. 2 is a schematic diagram illustrating the structure of a fixing section attached to a spacer.
[fig.3]FIG. 3 is a schematic diagram illustrating the effect produced by the fixing section attached to the spacer.
[fig.4]FIG. 4 is a flow chart illustrating the method for producing the imaging device depicted in FIG. 1.
[fig.5]FIG. 5 is a diagram illustrating one example of the structure of the imaging device according to a second embodiment disclosed herein.
[fig.6]FIG. 6 is a diagram illustrating one example of the structure of the imaging device according to a third embodiment disclosed herein.
[fig.7]FIG. 7 is a diagram illustrating one example of the structure of the imaging device according to a fourth embodiment disclosed herein.
[fig.8]FIG. 8 is a diagram illustrating one example of the structure of the imaging device according to a fifth embodiment disclosed herein.
[fig.9]FIG. 9 is a diagram illustrating one example of the structure of the imaging device according to a sixth embodiment disclosed herein.
[fig. 10] FIG. 10 is a diagram illustrating one example of the structure of the imaging device according to a seventh embodiment disclosed herein.
[fig.11]FIG. 11 is a diagram illustrating one example of the arrangement of the fixing section.
[fig.12]FIG. 12 is a diagram illustrating one example of the structure of the CSP solid-state imaging element disclosed herein.
[fig.13]FIG. 13 is a block diagram illustrating one example of the imaging device as an electronic apparatus to which is applied the structure of the imaging device disclosed herein.
[fig.14]FIG. 14 is a diagram illustrating the examples of use of the imaging device to which is applied the disclosed technology.
[fig.15]FIG. 15 is a schematic diagram illustrating one example of the structure of an endoscopic surgery system.
[fig.16]FIG. 16 is a block diagram illustrating one example of the functional structure of the camera head and camera control unit (CCU).
[fig.17]FIG. 17 is a schematic diagram depicting one example of the structure of a vehicle control system.
[fig.18]FIG. 18 is a diagram illustrating one example of the arrangement of imaging units and an external information detecting section.

### Description of Embodiments

The following is a detailed description of the preferred embodiments of the present disclosure. It refers to the accompanying drawings, in which the constituent elements having identical functions are given identical codes to avoid duplication.

The following description proceeds in the following order.
1. First embodiment
2. Second embodiment
3. Third embodiment
4. Fourth embodiment
5. Fifth embodiment
6. Sixth embodiment
7. Seventh embodiment
8. Structure of CSP solid-state imaging element
9. Examples of application to electronic apparatuses
10. Example of application of imaging element
11. Example of application to endoscopic surgery system
12. Example of application to mobile bodies

### 1. First embodiment

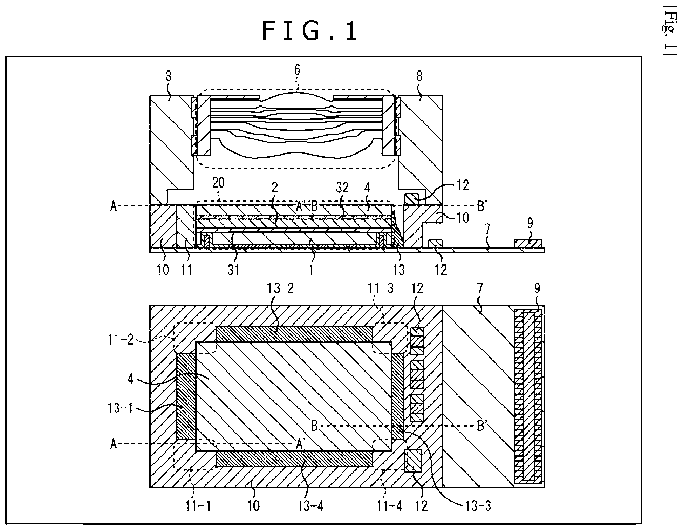

The imaging device as the first embodiment to which is applied the solid-state imaging element of the present disclosure is constructed as depicted in FIG. 1. The upper part of FIG. 1 depicts the side sectional view of the imaging device and the lower part of FIG. 1 depicts the top sectional view taken along the line AB' of the imaging device. Incidentally, the upper left half of FIG. 1 is a sectional view taken along the line AA' depicted in the lower part, and the upper right half of FIG. 1 is a sectional view taken along the line BB' in the lower part.

The imaging device depicted in FIG. 1 includes a CSP solid-state imaging element 20, a lens 6, a circuit substrate 7, an actuator 8, and a spacer 10.

The CSP solid-state imaging element 20 is one which integrally includes a solid-state imaging element 1, a glass substrate 2, and an infrared cut filter 4.

To be more specific, the solid-state imaging element 1 is an image sensor formed from charge coupled device (CCD) or complementary metal oxide semiconductor (CMOS). It receives light through the lens 6, generates charges by means of photoelectric conversion in response to the amount of light received, and outputs pixel signals including electric signals corresponding to the charges. The solid-state imaging element 1 and the glass substrate 2 are bonded together with a clear adhesive 31. The infrared cut filter 4 is a filter to remove infrared rays, and it is bonded to the glass substrate 2 with the clear adhesive 32.

The CSP solid-state imaging element 20 is constructed as depicted in FIG. 1, so that it is treated as one part in the assembling step.

The lens 6 causes the light from the object to converge on the imaging surface of the solid-state imaging element 1. It includes one or more lens elements.

The actuator 8 moves the lens 6 in the vertical and horizontal directions (in the figure) with respect to the solid-state imaging element 1. It has at least one function of auto-focusing and image stabilization.

The circuit substrate 7 functions to deliver outward the electrical signals from the CSP solid-state imaging element 20. The spacer 10 connects the CSP solid-state imaging element 20 to the circuit substrate 7 by means of a fixing agent 13. The spacer 10 also supports the actuator 8 on its upper surface, so that the lens 6 and the actuator 8 are fastened.

On the circuit substrate 7 and the spacer 10 are supported the capacitors and semiconductor parts 12, such as actuator-controlling large-scale integration (LSI), which are necessary to drive the solid-state imaging element 1 and the actuator 8 for the CSP solid-state imaging element 20.

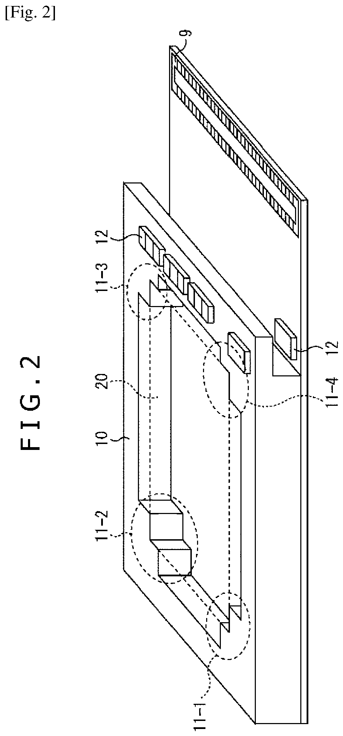

Moreover, the CSP solid-state imaging element 20 has its four angular sections fitted into fixing sections 11-1 to 11-4 formed in the spacer 10, as depicted in FIG. 2. This structure permits the CSP solid-state imaging element 20 to be led and fixed to an adequate position on the circuit substrate 7 only by gravity action even though the angular sections are merely fitted, with the fixing agent 13 not yet injected into the circuit substrate 7. In other words, the fixing sections 11-1 to 11-4 are formed in the spacer 10 in such a way as to lead the four angular sections of the CSP solid-state imaging element 20 to an adequate position on the circuit substrate 7 as soon as the CSP solid-state imaging element 20 is fitted into the opening of the spacer 10.

Incidentally, the fixing sections 11-1 to 11-4 are formed in such a size that there will be a very small gap (that merely permits a crossover) between the fixing sections 11-1 to 11-4 and the CSP solid-state imaging element 20 when the CSP solid-state imaging element 20 is arranged at an adequate position in the opening of the spacer 10. However, the fixing sections 11-1 to 11-4 are so constructed as to come into contact with the CSP solid-state imaging element 20 and lead it to an adequate position when the CSP solid-state imaging element 20 suffers warpage, distortion, or shrinkage, thereby protecting the CSP solid-state imaging element 20 from tilt and displacement resulting from its warpage, distortion, or shrinkage.

Consequently, the CSP solid-state imaging element 20 can be spontaneously led to and arranged at an adequate position on the circuit substrate 7 by its self-weight and gravity action as it is fitted into the spacer 10 in such a way that its four angular sections engage with the fixing sections 11-1 to 11-4 depicted in FIG. 2.

The advantage of the foregoing is that the CSP solid-state imaging element 20 remains at its position after it has been led to and arranged at an adequate position on the circuit substrate 7 and then the fixing agent 13 has been injected into the space between the CSP solid-state imaging element 20 and the spacer 10. This prevents the CSP solid-state imaging element 20 from warping, distorting, and tilting relative to the circuit substrate 7 even though the fixing agent 13 undergoes deformation before the fixing agent 13 dries and cures (solidifies).

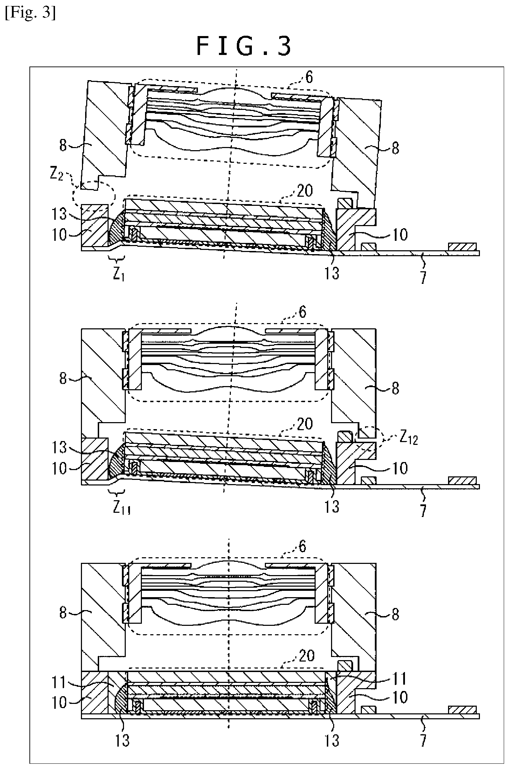

To be more specific, the foregoing is not true in the case where the spacer 10 is not provided with the fixing sections 11-1 to 11-4. In this case, as depicted in the upper part of FIG. 3, the circuit substrate 7 which is thin and liable to deformation is likely to bend (as indicated by Z₁ in the upper part of FIG. 3) while the fixing agent 13 still remains uncured after it has been injected into the space between the CSP solid-state imaging element 20 and the spacer 10. Such bending results in a section in which the actuator 8 and the spacer 10 do not adequately engage with each other as indicated by the dotted circle Z₂ in the upper part of FIG. 3. This misalignment is liable to cause the optical axis of the lens 6 to incline relative to the axis of the light receiving surface of the solid-state imaging element 1 as indicated by the dotted line.

Also, by the same token, the circuit substrate 7 which is thin and liable to deformation is likely to bend (as indicated by Z₁₁ in the middle part of FIG. 3) while the fixing agent 13 still remains uncured after it has been injected. Such bending results in a section in which the actuator 8 and the spacer 10 do not adequately engage with each other as indicated by the dotted circle Z₁₂ in the middle part of FIG. 3. This misalignment is liable to cause the optical axis of the lens 6 to incline relative to the axis of the light receiving surface of the solid-state imaging element 1 as indicated by the dotted line.

By contrast, the foregoing is not true in the case where the spacer 10 is provided with the fixing sections 11-1 to 11-4. In this case, the CSP solid-state element 20 has its four angular sections led to an adequate position by the fixing sections 11-1 to 11-4 even though the fixing agent 13 is not yet injected into the space between the CSP solid-state element 20 and the spacer 10. In other words, the CSP solid-state element 20 is led to and fixed at a nearly accurate position by its self-weight and gravity even though it is simply placed. Therefore, the CSP solid-state element 20 is relieved from distortion, warpage, and tilt (such as those depicted in the upper and middle parts of FIG. 3) while the fixing agent 13 still remains uncured after it has been injected. The result is that the CSP solid-state element 20 is fixed by the fixing agent 13 at an adequate position without suffering distortion, warpage, and tilt, as depicted in the lower part of FIG. 3.

Also, it is known that the CSP solid-state imaging element 20 is subject to distortion, warpage, and tilting due to high temperatures and external forces which are involved not only during production but also during use. However, the CSP solid-state imaging element 20 is saved from distortion, warpage, and tilting as the result of being fastened by the fixing sections 11-1 to 11-4 and bonded to the spacer 10 with the injected fixing agent 13.

As the result, the CSP solid-state imaging element 20 is free from distortion, warpage, and tilting, and this leads to the imaging device having improved optical properties which is produced in good yields. Thus there is obtained a high-performance imaging device which is small and thin.

Incidentally, the foregoing arrangement may be modified such that the spacer 10 is provided with the same circuit structure as that on the circuit substrate 7. Moreover, the circuit substrate 7 may be formed from a material having a coefficient of linear expansion close to that of silicon (from which the solid-state imaging element 1 is formed) and also having an elastic modulus lower than a prescribed value.

Moreover, the actuator 8 may have at least one of the auto-focusing function and the image stabilizing function. The actuator 8 may also be a lens holder for a short-focus lens having neither the auto-focusing function nor the image stabilizing function.

Also, the actuator is not the only means to realize the auto-focusing function and image stabilizing function.

### <Method for producing imaging device>

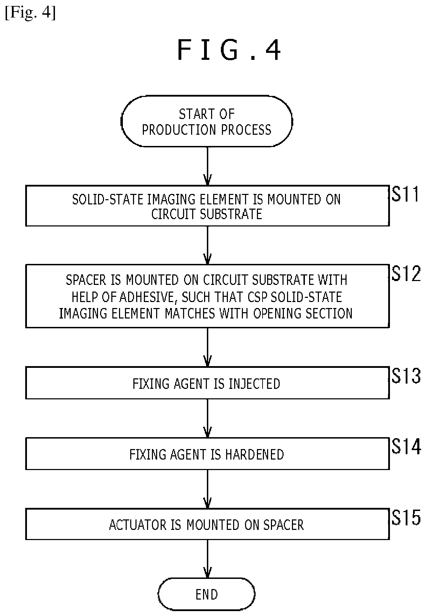

The following concerns with the method for producing the imaging device depicted in FIG. 1, which is described with reference to the flow chart depicted in FIG. 4.

In Step S11, the CSP solid-state imaging element 20 is mounted on the circuit substrate 7.

In Step S12, the spacer 10 is mounted on and fixed (with an adhesive) to the circuit substrate 7 in such a way that the fixing sections 11-1 to 11-4 of the spacer 10 cause the four angular sections of the CSP solid-stage imaging element 20 to be led to and fitted into an adequate position on the circuit substrate 7. As the result, the CSP solid-state imaging element 20 is led to an adequate position (suitable for electrical connection) on the circuit substrate 7 by the fixing sections 11-1 to 11-4 and the self-weight and the gravity action, no matter how thin and liable to deformation the circuit substrate 7 may be.

In Step S13, the fixing agent 13 is injected into a space between the CSP solid-state imaging element 20 and the spacer 10. In Step S14, the fixing agent 13 is cured (solidified). As the result, the CSP solid-state imaging element 20, the spacer 10, and the circuit substrate 7 are bonded together by the fixing agent 13. The CSP solid-state imaging element 20 remains arranged at an adequate position by the fixing sections 11-1 to 11-4 until the fixing agent 13 solidifies after the injection of the fixing agent 13. Thus, the CSP solid-state imaging element 20 is properly fixed without deformation, warpage, and tilting.

In Step S15, the actuator 8 is mounted on the spacer 10.

The production method mentioned above permits the CSP solid-state imaging element 20 to be arranged at an adequate position on the circuit substrate 7 which is thin and easily bendable and to be fixed thereto with the fixing agent 13.

The foregoing production method makes it possible to produce the imaging device in high yields without deteriorating the optical properties thereof and to realize the high-performance imaging device which is small and thin.

### 2. Second embodiment

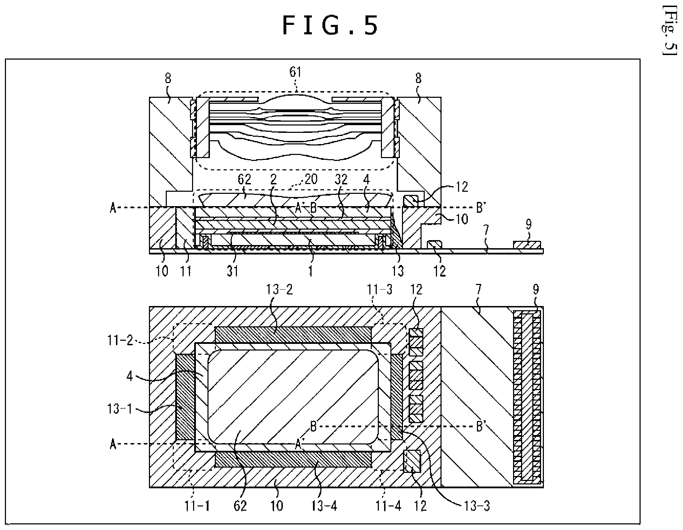

The recent market demand for the miniaturization of cameras has invoked an imaging device of new type. The lens 6 depicted in FIG. 1 is modified such that it includes two lens groups 61 and 62 as depicted in FIG. 5. The upper lens group 61 is separate from the lower lens group 62 which is arranged immediately above the solid-state imaging element 1. This structure may also be applied to the imaging device according to an embodiment of the present disclosure.

For example, the imaging device depicted in FIG. 5 is constructed such that the lower lens group 62 is arranged on the infrared cut filter 4. This structure contributes to a small and thin imaging device which has reduced optical distortion and tilting as in the case of the imaging device depicted in FIG. 1.

Incidentally, the CSP solid-state imaging element 20 for the imaging device depicted in FIG. 5 is constructed such that the CSP solid-state imaging element 20 depicted in FIG. 1 additionally has the lower lens group 62 which is integrally arranged on the top thereof.

Moreover, the lens 6 may be constructed of two or more lens groups. In this case, as long as each lens group is configured by at least one lens, each lens group may include as many lens elements as necessary.

### 3. Third embodiment

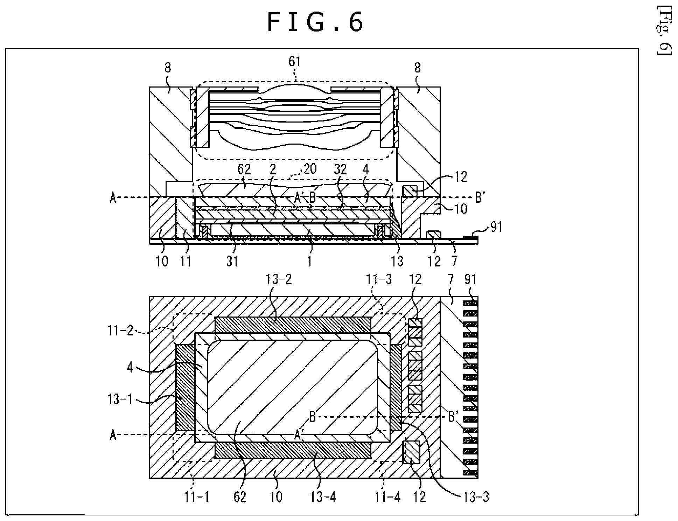

The recent market demand for the diversification of cameras has made the imaging device to have the circuit substrate 7 which varies in shape from one model of camera to another. This object is achieved by replacing the connector 9 with the ACF unit 91 which is arranged on the circuit substrate 7, as depicted in FIG. 6. The thus modified structure helps realize the small and thin imaging device with a minimum of optical distortion, bending, and tilting (corresponding to diversified cameras) without the necessity of changing the production system.

### 4. Fourth embodiment

The imaging device depicted in FIGS. 1, 5, and 6 is provided with the infrared cut filter 4 suffering a minimum of distortion and bending, which is usually expensive.

Moreover, the infrared cut filter 4 to be mounted on the CSP solid-state imaging element 20 should be an expensive one because it adversely affects the solid-state imaging element 1 (in terms of distortion, bending, and tilting) if it suffers distortion and bending.

For this reason, the infrared cut filter 4 may be mounted on the imaging device as an external unit of the CSP solid-state imaging element 20.

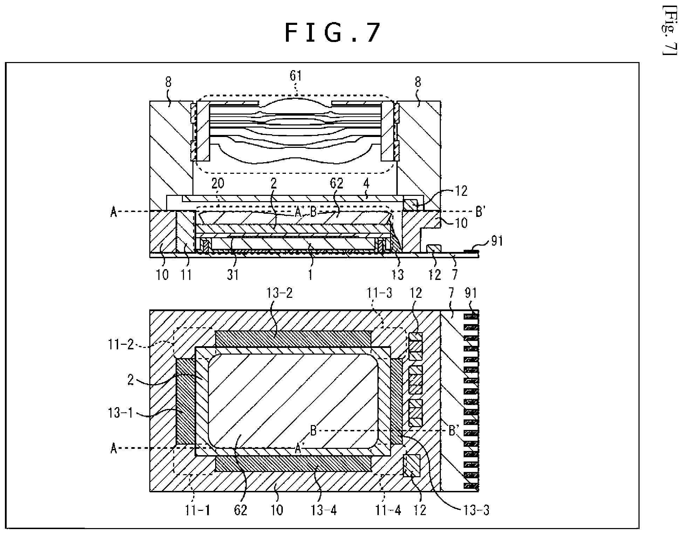

FIG. 7 depicts an example of the imaging device which is constructed such that the infrared cut filter 4 functions as an external unit of the CSP solid-state imaging element 20 and which is mounted below the actuator 8.

The imaging device depicted in FIG. 7 has the infrared cut filter 4 which functions as an external unit of the CSP solid-state imaging element 20 and which is mounted on the lowermost part of the actuator 8. This structure helps the infrared cut filter 4, no matter how cheap it may be, to circumvent optical distortion and tilting because it is an external unit of the CSP solid-state imaging element 20.

The foregoing brings about the possibility of realizing at a low cost the imaging device which is small and thin and is less liable to optical distortion, bending, and tilting.

Incidentally, the CSP solid-state imaging element 20 of the imaging device depicted in FIG. 7 is identical with the CSP solid-state imaging element 20 depicted in FIG. 5 except that the infrared cut filter 4 is omitted.

### 5. Fifth embodiment

The foregoing embodiment is constructed in such a way that the infrared cut filter 4 is mounted on the lowermost part of the actuator 8 and hence is separate from the CSP imaging element 20. This structure permits the adoption of the infrared cut filter 4 which has a minimum of bending and distortion, which contributes to cost reduction. However, the infrared cut filter 4 may be replaced by one which is made of the same material as the glass substrate 2 and is capable of reducing the passage of infrared rays.

In other words, the infrared cut filter 4 with a minimum of bending and distortion may be substituted with the glass substrate 2 which is a basic constituent of the imaging device depicted in FIGS. 1, 5, and 6.

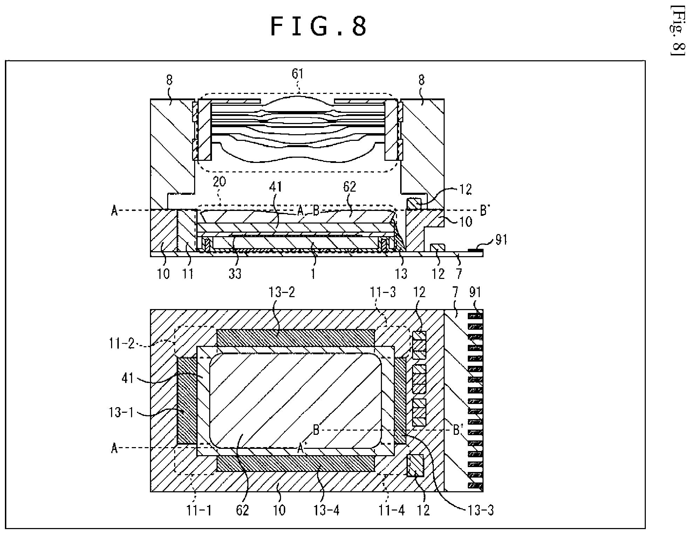

FIG. 8 depicts an example of the structure of the imaging device which adopts a glass substrate 41 as a substitute for the infrared cut filter 4 having a minimum of bending and distortion, the glass substrate 41 being made of the same material as the glass substrate 2 as the basic constituent of the imaging device depicted in FIGS. 1, 5, and 6 and being capable of reducing the passage of infrared rays.

The structure just mentioned above suppresses bending and distortion without the necessity of using the expensive infrared cut filter 4 having a minimum of bending and distortion. This helps economically realize the small and thin imaging device which is less liable to bending, tilting, and optical distortion.

Incidentally, the CSP solid-state imaging element 20 in the imaging device depicted in FIG. 8 differs in structure from that depicted in FIG. 5 in that the infrared cut filter 4 is omitted and the glass substrate 2 is substituted with the glass substrate 41 capable of cutting infrared rays and that the glass substrate 41 is bonded to the solid-state imaging element 1 by a clear adhesive 33. The glass substrate 41 capable of cutting infrared rays may be a bluish sheet glass which absorbs infrared rays.

### 6. Sixth embodiment

The foregoing embodiment is constructed in such a way that the infrared cut filter 4 is substituted with the glass substrate 41. However, this structure may be modified such that the infrared cut filter 4 is interposed between the glass substrate 2 and the solid-state imaging element 1. In this case, the infrared cut filter 4 may be an inexpensive one.

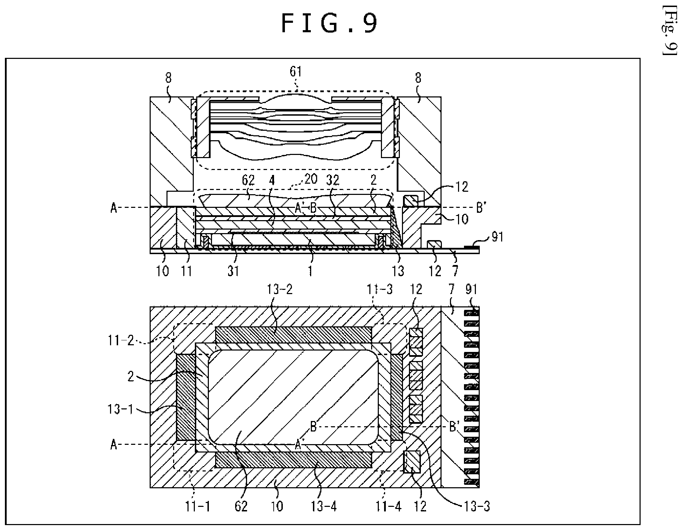

In the imaging device depicted in FIG. 9, the CSP solid-state imaging element 20 is mounted thereon which is provided with the infrared cut filter 4 having a minimum of bending and distortion. The reduction of bending and distortion in this case is achieved by interposing the infrared cut filter 4 between the solid-state imaging element 1 and the glass substrate 2 having limited bending and distortion.

The structure just mentioned above physically prevents the inexpensive infrared cut filter 4 from suffering bending and distortion. Thus, it permits the economical production of the small and thin imaging device with a minimum of bending, tilting, and optical distortion.

There is a difference between the CSP solid-state imaging element 20 in the imaging device depicted in FIG. 9 and the CSP solid-state imaging element 20 in the imaging device depicted in FIG. 5 in the reversed arrangement of the infrared cut filter 4 and the glass substrate 2.

### 7. Seventh embodiment

The foregoing embodiment is constructed in such a way that the fixing sections 11-1 to 11-4 lead the four angular sections of the CSP solid-state imaging element 20 on the spacer 10 to an adequate position. However, the fixing sections 11-1 to 11-4 may be arranged at any other positions as explained below.

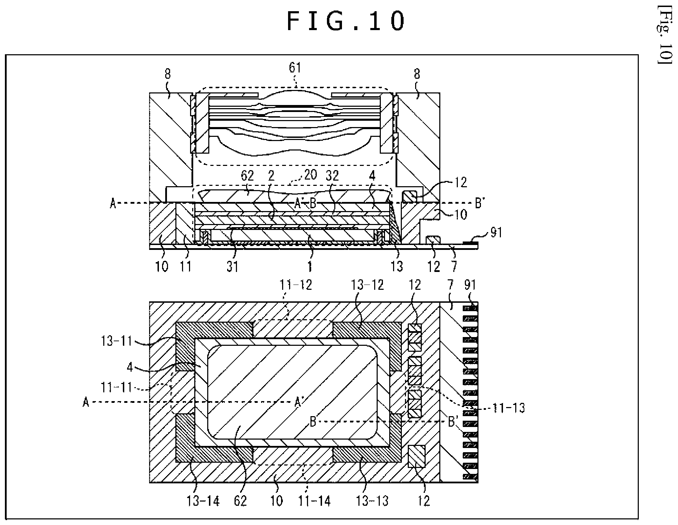

FIG. 10 depicts an example of the structure of the imaging device in which the fixing sections 11-1 to 11-4 are replaced by fixing sections 11-11 to 11-14.

To be more specific, the fixing sections 11-11 to 11-14 are arranged on the spacer 10 such that the four sides of the CSP solid-state imaging element 20 are properly placed, with the approximate center of each of the four sides led to an adequate position. In response to this arrangement, the fixing agent 13 is injected into the vicinity of the four angular sections of the CSP solid-state imaging device 20 so that fixation to the spacer 10 is achieved.

Since the fixing sections 11 are so arranged as to lead the four sides of the CSP solid-state imaging element 20 to their respective adequate positions, the CSP solid-state imaging element 20 can be highly accurately arranged on the circuit substrate 7.

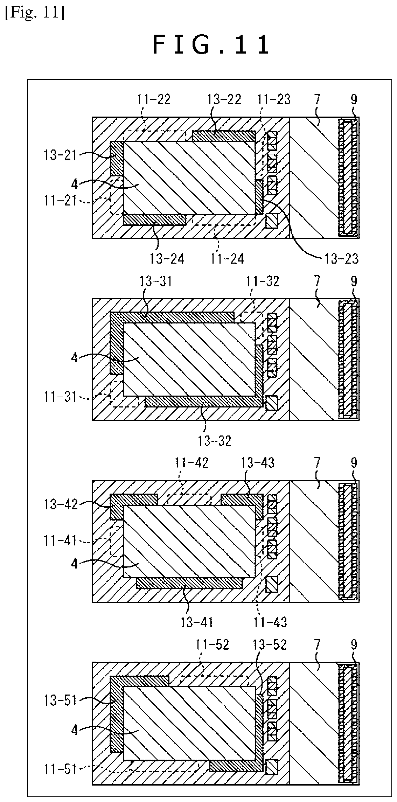

The arrangement of the fixing sections 11 is not restricted to that mentioned above. An example of such modification is depicted in the top of FIG. 11. Fixing sections 11-21 to 11-24 are formed at the end of each side of the CSP solid-state imaging element 20 on the spacer 10. In this case, the fixing agent 13 injected is indicated by fixing agents 13-21 to 13-24.

Another example of modification is depicted in the second upper part of FIG. 11. The fixing sections 11-31 and 11-32 are formed at the two corners on any one of the diagonal lines of the CSP solid-state imaging element 20 on the spacer 10. In this case, the fixing agent 13 injected is indicated by fixing agents 13-31 and 13-32. Thus, the fixing sections 11-31 and 11-32 fix the four sides of the CSP solid-state imaging element 20 also in the example of modification depicted in the second upper part of FIG. 11.

The fixing sections 11 are not necessarily designed such that all of the four sides of the CSP solid-state imaging element 20 are led to adequate positions. It may be alternatively designed such that part of the four sides is led to an adequate position. This design is still effective in more accurate arrangement than that without the fixing sections 11.

Further another example of modification is depicted in the second lower part of FIG. 11. Fixing sections 11-41 to 11-43 are formed which lead the three sides of the CSP solid-state imaging element 20 to adequate positions on the spacer 10. In this case, the fixing agent 13 injected is indicated by fixing agents 13-41 to 13-43. Thus, the fixing sections 11-41 to 11-43 fix the three sides of the CSP solid-state imaging element 20. The CSP solid-state imaging element 20 is arranged at an adequate position at least in the direction in which the opposite sides are fixed.

Further another example of modification is depicted in the lowermost part of FIG. 11. Fixing sections 11-51 and 11-52 are formed which lead the opposite sides of the CSP solid-state imaging element 20 to adequate positions on the spacer 10. In this case, the fixing agent 13 injected is indicated by fixing agents 13-51 and 13-52. Thus, the fixing sections 11-51 and 11-52 fix the upper and lower opposite sides of the CSP solid-state imaging element 20. The CSP solid-state imaging element 20 is arranged at an adequate position at least in the direction in which the upper and lower sides oppose to each other.

Since the fixing sections 11 are so arranged as to lead the opposite sides of the CSP solid-state imaging element 20 to their respective adequate positions, the CSP solid-state imaging element 20 can be highly accurately arranged.

### 8. Structure of CSP solid-state imaging element

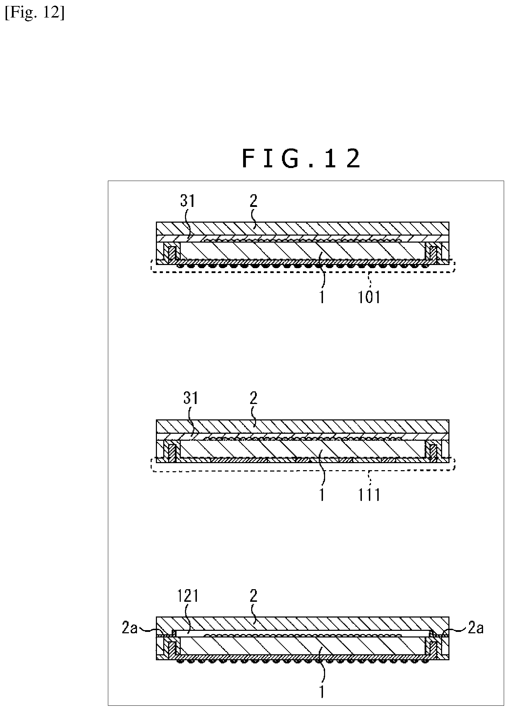

The CSP solid-state imaging element 20 may be modified in its structure such that the circuit substrate 7 has the connecting section which is either a ball grid array (BGA) terminal 101 (depicted in the upper part of FIG. 12) or a land grid array (LGA) terminal 111 (depicted in the middle part of FIG. 12).

The CSP solid-state imaging element 20 may also be modified in its structure such that the glass substrate 2 is provided with a frame 2a on its periphery (as depicted in lower part of FIG. 12), with the frame 2a forming a cavity 121 between the solid-state imaging element 1 and the glass substrate 2.

The connecting sections mentioned above, whatever their structure may be, contributes to realize the small and thin imaging device with a minimum of bending, tilting, and optical distortion.

According to the disclosure mentioned above, it is possible to produce the small and thin imaging device which is less liable to bending, distortion, and tilting at the time of mounting of the CSP solid-state imaging element. It will find use as a central component of the small and thin high-performance imaging device to be produced in high yields without adverse optical effects.

### 9. Examples of application to electronic apparatuses

The above-mentioned imaging element will be applied to various electronic apparatuses including imaging devices (such as digital still cameras and digital video cameras), portable telephones (with imaging function), and any other devices (with imaging function).

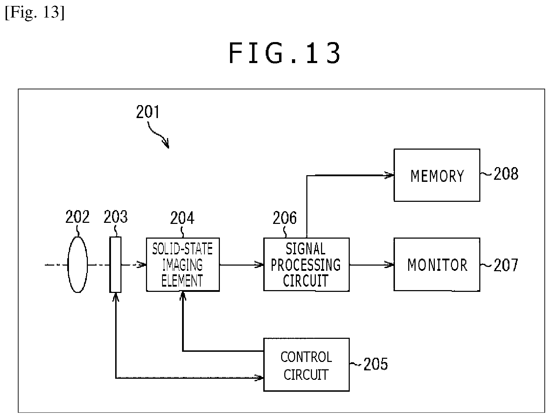

An example of the electronic apparatus to which the present technology is applied is the imaging device illustrated in FIG. 13 as a block diagram for the structure.

An imaging device 201 depicted in FIG. 13 includes an optical system 202, a shutter unit 203, a solid-state imaging element 204, a drive circuit 205, a signal processing circuit 206, a monitor 207, and a memory 208, so that it is capable of photographing still images and dynamic images.

The optical system 202 includes one or more lenses. It leads the light (incident light) from the object to the solid-state imaging element 204, thereby forming an image on the light receiving surface of the solid-state imaging element 204.

The shutter unit 203 is interposed between the optical system 202 and the solid-state imaging element 204. It controls the period of time during which the solid-state imaging element 204 is exposed to and blocked from the light in response to signals from the drive circuit 205.

The solid-state imaging element 204 includes the package containing the above-mentioned solid-state imaging element. It stores signal charges for a prescribed period of time in response to the image formed on the image-forming surface by the light which has passed through the optical system 202 and the shutter unit 203. The signal charges thus stored in the solid-state imaging element 204 are transferred in response to the drive signal (timing signal) supplied from the drive circuit 205.

The drive circuit 205 outputs drive signals to control the transfer action of the solid-state imaging element 204 and the shutter action of the shutter unit 203, thereby driving the solid-state imaging element 204 and the shutter unit 203.

The signal processing circuit 206 variously performs signal processing on the signal charges output from the solid-state imaging element 204. The signal processing performed by the signal processing circuit 206 produces the image (or image data), which is subsequently supplied to the monitor 207 for display thereon and also to the memory 208 for recording therein.

The imaging device 201 constructed as mentioned above has the optical system 202 and the solid-state imaging element 204 which are based on respectively the lens 6, 61, or 62 and the CSP solid-state imaging element 20 mounted on the imaging device depicted in FIGS. 1 and 5 to 10 depicted above. Consequently, the imaging device 201 can be produced efficiently without deterioration in yields performance.

### 10. Example of application of imaging element

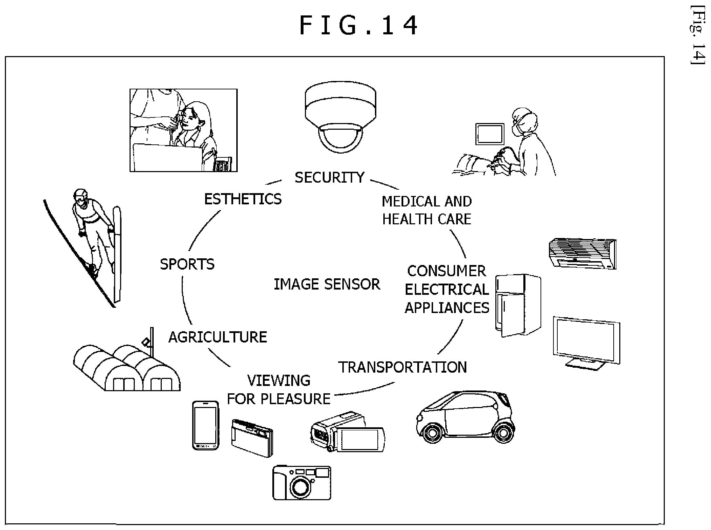

The imaging device depicted in FIGS. 1 and 5 to 12 will find use in various applications whose examples are depicted in FIG. 14.

The imaging element mentioned above will be used as a sensing device for visible rays, infrared ray, ultraviolet rays, X-rays, etc. in various fields as exemplified below.
- Digital cameras, portable equipment with camera, and imaging device to take pictures for pleasure.
- Any equipment for transportation which includes on-vehicle sensors and monitoring cameras. The former is intended to photographing the front, rear, periphery, and inside of the car, thereby contributing to safe driving (such as automatic stopping) and checking the driver's condition, and the latter is intended to watch the running vehicles and the roads and to measure the vehicular gap.
- Devices to be incorporated into electric appliance (such as television (TV) sets, refrigerators, and air conditioners), which are so designed as to photograph the user's gesture and operate the equipment in response to the resulting photograph.
- Devices for medical treatment and health care, which include endoscopes and devices to photograph blood vessels with the help of infrared rays.
- Devices involved in security, such as surveillance cameras for crime prevention and personal recognition cameras.
- Devices (including microscopes) for esthetics, which are intended to photograph the skin and scalp.
- Devices for sports, such as action cameras and wearable cameras.
- Devices for agriculture, such as cameras to monitor the conditions of farms and crops.

### 11. Example of application to endoscopic surgery system

The technology (present technology) according to the present disclosure may be applied to various products. For example, it will find use for the endoscopic surgery system.

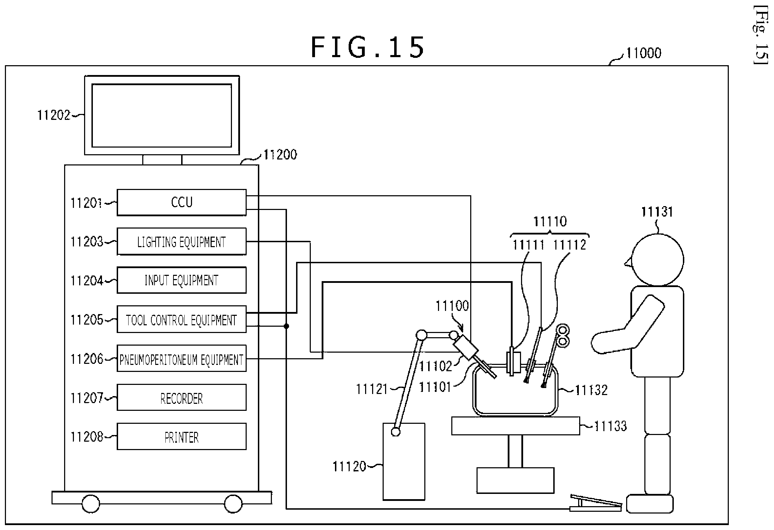

FIG. 15 is a schematic diagram depicting the endoscopic surgery system to which is applied the technology (present technology) of the present disclosure.

Depicted in FIG. 15 is an endoscopic surgery system 11000 which is being used for a patient 11132 on a bed 11133 by the manipulator (doctor) 11131. The endoscopic surgery system 11000 includes an endoscope 11100, miscellaneous tools 11110 (such as a Pneumoperitoneum tube 11111 and an energy controller 11112), an arm device 11120 to support the endoscope 11100, and a cart 11200 to carry various tools for the endoscopic surgery.

The endoscope 11100 includes a lens barrel 11101, which is inserted into the body cavity of the patient 11132 (as deep as the prescribed length from the fore-end thereof), and a camera head 11102, which is attached to the base end of the lens barrel 11101. The illustrated endoscope 11100 is of rigid type which is provided with the rigid lens barrel 11101. However, the rigid lens barrel 11101 may be replaced by a flexible one.

The lens barrel 11101 has, at the fore-end thereof, the opening into which an object lens is fitted. The endoscope 11100 is provided with lighting equipment 11203 which generates light to be introduced to the fore-end of the lens barrel 11101 through the light guide extending inside thereof, for illumination of the body cavity of the patient 11132 through the object lens. Incidentally, the endoscope 11100 may be of direct viewing type, oblique viewing type, or side viewing type.

The camera head 11102 has inside thereof an optical system and an imaging element. The optical system makes the reflected light (observation light) from the object converge on the imaging element. Thus, the observation light undergoes photoelectric conversion, thereby producing electrical signals or image signals corresponding to the observed image. The image signals (in the form of RAW data) are transmitted to a CCU 11201.

The CCU 11201 includes a central processing unit (CPU), a graphic processing unit (GPU), and others. It generally controls the action of the endoscope 11100 and a display unit 11202. Moreover, the CCU 11201 receives image signals from the camera head 11102 and performs various image processing (such as development or demosaic process) on the thus received image signals, thereby displaying the image in response to the image signals.

The display unit 11202 under control from the CCU 11201 displays the image in response to the image signal which has undergone image processing by the CCU 11201.

Lighting equipment 11203 may be a light source such as light emitting diode (LED). It supplies light to the endoscope 11100 to illuminate the affected part under surgery.

Input equipment 11204 functions as an input interface for the endoscopic surgery system 11000. The input equipment 11204 permits the manipulator to enter various kinds of information and instruction into the endoscopic surgery system 11000. Such instructions may include the change of imaging conditions (e.g., type of illuminating light, magnification ratio, and focal length) by the endoscopic surgery system 11000.

Tool control equipment 11205 drives the energy controller 11112 which performs tissue burning, incision, or blood vessel sealing. Pneumoperitoneum equipment 11206 feeds a gas into the body cavity through the pneumoperitoneum tube 11111, thereby expanding the body cavity of the patient 11132. This step is intended to ensure the field of view for the endoscope 11100 and to ensure the working space for the manipulator. A recorder 11207 records various kinds of information about surgery. A printer 11208 pints out various kind of information about surgery in the form of text, image, or graph.

The lighting equipment 11203 which supplies light to the endoscope 11100 for illumination of the affected part under surgery may be a white light source such as LED or laser oscillator or a combination thereof. A white light source based on the combination of red, green, and blue (RGB) laser sources is desirable because it permits the highly accurate control of output intensity and output timing for individual colors (or wavelengths). This permits the lighting equipment 11203 to adjust the white balance of the image. To this end, the individual laser beams corresponding to the RGB laser sources are directed to the object on the time-sharing basis, and the imaging element of the camera head 11102 is driven in synchronism with the illumination timing. In this way, it is possible to photograph the images corresponding to RGB on the time-sharing basis. This system gives rise to color images without necessity of providing the imaging element with color filters.

The lighting equipment 11203 may also be controlled such that it varies at certain time intervals in the intensity of light it generates. In synchronism with the timing at which the light intensity varies, the imaging element of the camera head 11102 acquires the images on the time-sharing basis. The thus acquired images are synthesized into a single image having a high dynamic range free of so-called blocked-up shadow and overexposed white.

The lighting equipment 11203 may also be one which is so constructed as to produce light having a specific bandwidth of wavelength suitable for observation with special light. The observation with special light is performed by utilizing the fact that the absorption of light by the body tissue varies depending on the wavelength of the light to be absorbed. In other words, it employs light of narrower band than that of white light for ordinary observation or it employs light for so-called narrow band imaging by which a predetermined tissue such as blood vessel on the mucous surface is photographed. Moreover, the observation with special light may include the observation with fluorescence which is intended to acquire images with the help of fluorescence generated by irradiation with exciting light. The observation with fluorescence may be achieved with the help of fluorescence which is emitted from the body tissue upon irradiation with exciting light (autofluorescence observation). Alternatively, the observation with fluorescence may also be achieved by local injection of a reagent such as indocyanine green (ICG) into the body tissue which is subsequently undergoes irradiation with exciting light corresponding to the wavelength of fluorescence produced by the reagent so that the body tissue is photographed. Therefore, the lighting equipment 11203 may be so constructed as to produce the narrow band light and/or exciting light suitable for the observation with special light as mentioned above.

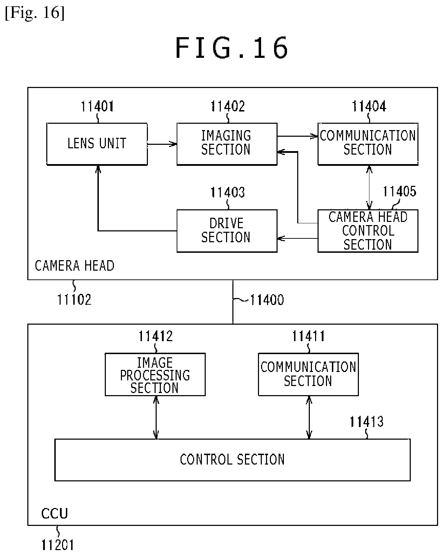

FIG. 16 is a block diagram illustrating each composition of the camera head 11102 and the CCU 11201, both depicted in FIG. 15.

The camera head 11102 includes a lens unit 11401, an imaging section 11402, a drive section 11403, a communication section 11404, and a camera head control section 11405. The CCU 11201 includes a communication section 11411, an image processing section 11412, and a control section 11413. The camera head 11102 and the CCU 11201 are connected with each other for communication through a transmission cable 11400.

The lens unit 11401 is an optical system placed in the section through which it is connected to the lens barrel 11101. The lens barrel 11101 permits the light for observation to enter through the forward end thereof, and the light reaches the camera head 11102 and enters the lens unit 11401. The lens unit 11401 includes several lens elements including zoom lens and focusing lens.

The imaging section 11402 includes one imaging element (so-called single plate type) or a plurality of imaging elements (so-called multiple plate type). In the latter case, the individual imaging elements generate image signals corresponding to RGB colors, and such image signals are synthesized into a single color image. Alternatively, the imaging section 11402 may include a pair of imaging elements which acquire image signals for the right and left eyes for three-dimensional (3D) display. The 3D display permits a manipulator 11131 to accurately grasp the depth of the living tissue under surgery. Incidentally, in the case of the imaging section 11402 of multiple plate type, there will be a plurality of lens units 11401 for each imaging element.

It is not necessarily essential for the imaging section 11402 to be attached to the camera head 11102. For example, the imaging section 11402 may be placed just behind the object lens in the lens barrel 11101.

The drive section 11403 is an actuator which moves the zoom lens and focusing lens constituting the lens unit 11401 over a prescribed distance along the optical axis in response to signals from the camera head control section 11405. Thus, the actuator causes the imaging section 11402 to adjust itself to an adequate power and focus for the image to be photographed.

The communication section 11404 includes apparatuses to send and receive various kinds of information to and from the CCU 11201. In other words, the communication section 11404 receives image signals from the imaging section 11402 and then sends them (in the form of RAW data) to the CCU 11201 through the transmission cable 11400.

In addition, the communication section 11404 receives from the CCU 11201 control signals to drive the camera head 11102 and then supplies them to the camera head control section 11405. The control signals include information to specify the frame rate of images, the exposure value for photographing, the power and focus of images, and the imaging conditions.

Incidentally, the imaging conditions (such as frame rate, exposure value, power, and focus) may be appropriately specified by the manipulator, or may be automatically set up by the control section 11413 of the CCU 11201 in response to the previously acquired image signals. The latter case means that the endoscope 11100 has the auto exposure (AE) function, the auto exposure (AF) function, and the auto white balance (AWB) function.

The camera head control section 11405 drives the camera head 11102 in response to the control signals from the CCU 11201 which have been received through the communication section 11404.

The communication section 11411 includes communication apparatuses to send and receive various kinds of information to and from the camera head 11102. Moreover, the communication section 11411 receives image signals dispatched from the camera head 11102 through the transmission cable 11400.

In addition, the communication section 11411 sends control signals to the camera head 11102 to be driven by the camera head 11102. The image signals and control signals can be sent by means of electrical communication or optical communication.

The image processing section 11412 performs various kinds of image processing on the image signals (in the form of RAW data) transmitted from the camera head 11102.

The control section 11413 performs various kinds of control on the photographing of the affected part by the endoscope 11100 and the display of photographed images of the affected part. For example, the control section 11413 generates control signals to drive the camera head 11102.

Also, the control section 11413 causes the display unit 11202 to display the image of the affected part under surgery in response to the image signals which have undergone image processing by the image processing section 11412. In this step, the control section 11413 may employ a variety of image recognition technique to recognize various objects in the images photographed. For example, the control section 11413 may detect the edge, shape, color, etc. of the objects contained in the images photographed. The result of such detection allows the manipulator to recognize surgery tools (e.g., forceps), position of specific parts of living body, bleeding, and mist of the energy controller 11112. The control section 11413 will use the results of such recognition to display a variety of surgery supporting information which is overlaid on the image being displayed on the display unit 11202. The surgery assisting information, which is overlaid on the display, will relieve the manipulator 11131 from his burden and helps the manipulator 11131 to securely carry out his surgery.

The camera head 11102 and the CCU 11201 are connected to each other through the transmission cable 11400, which may be an electric signal cable suitable for communication of electric signals or an optical fiber suitable for optical communication or a composite cable thereof.

In the example illustrated above, communication between the camera head 11102 and the CCU 11201 depends on the wire system using the transmission cable 11400. However, the wire system may be replaced by the wireless system.

The foregoing is a description of the example of the endoscopic surgery system to which the technology of the present disclosure is applied. The disclosed technology may be applied to the imaging section 11402 of the camera head 11102 of the endoscope 11100. To be more specific the imaging section 10402 may include the circuit substrate 7, the spacer 10, the fixing section 11, and the CSP solid-state imaging element 20 which are depicted in FIGS. 1 and 5 to 10. When applied to the imaging section 11402, the technology disclosed herein will permit the entire apparatus to be produced in higher yields without adverse effect on performance.

The technology disclosed herein will be applied to the endoscopic surgery system mentioned above and besides, for example, may be applied to any other fields such as microscopic surgery system.

### 12. Example of application to mobile bodies

The technology pertaining to the disclosure of the present disclosure may be applied to a variety products. For example, it will find use as an apparatus to be mounted on various kinds of mobile bodies, such as automobiles, electric cars, hybrid automobiles, motorcycles, bicycles, personal mobility, airplanes, drones, ships, and robots.

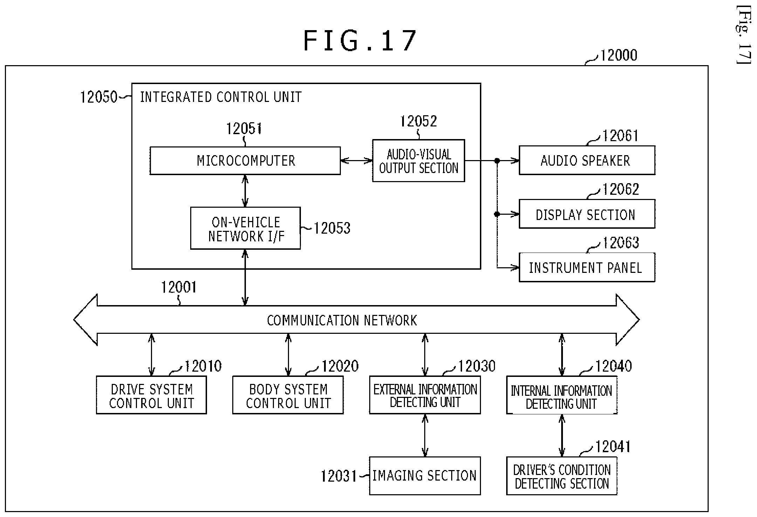

One example to which the technology disclosed herein is applied is the mobile body control system, more specifically the vehicle control system, which is illustrated by the block diagram in FIG. 17.

A vehicle control system 12000 depicted in FIG. 17 includes a plurality of electronic control units which are connected with one another through a communication network 12001. In the case of the illustrated example, the vehicle control system 12000 includes a drive system control unit 12010, a body system control unit 12020, an external information detecting unit 12030, an internal information detecting unit 12040, and an integrated control unit 12050. The integrated control unit 12050 includes of a microcomputer 12051, an audio-visual output section 12052, and an on-vehicle network interface (I/F) 12053.

The drive system control unit 12010 controls, in response to various programs, those apparatuses relating to the drive system of the vehicle. For example, the drive system control unit 12010 controls the equipment such as internal combustion engine or driving motor which generates the driving power for the vehicle, the mechanism to transmit the driving power to the wheels, the steering mechanism to control the vehicle's direction, and the device to brake the vehicle.

The body system control unit 12020 controls, in response to various programs, the action of the devices mounted on the vehicle. For example, the body system control unit 12020 controls the keyless entry system, the smart key system, the power window system, and various lamps such as head lamps, tail lamps, brake lamps, winkers, and fog lamps. It also receives various switch signals and electromagnetic waves transmitted from a portable device which functions as a substitute for the key. In addition, the body system control unit 12020 controls the door lock mechanism, power windows, and lamps upon reception of the electromagnetic waves and signals.

The external information detecting unit 12030 detects information about the outside of the vehicle equipped with the vehicle control system 12000. For example, the external information detecting unit 12030 has an imaging section 12031 connected thereto. Therefore, the external information detecting unit 12030 causes the imaging section 12031 to photograph images outside the vehicle and also receives the thus photographed image. The external information detecting unit 12030 may have additional functions to use the thus received image in order to detect objects such as people, vehicles, obstacles, traffic sings, and letters on the road or measure distance to such objects.

The imaging section 12031 is an optical sensor which receives light and outputs electrical signals in response to the amount of light received. The imaging section 12031 also outputs images or distance information in place of electrical signals. Moreover, the imaging section 12031 may receive visible light or invisible light such as infrared rays.

The internal information detecting unit 12040 detects information inside the vehicle. It is connected to a driver's condition detecting section 12041 which monitors the driver's condition through the camera installed therein which photographs the driver. The internal information detecting unit 12040 analyzes the information received from the driver's condition detecting section 12041 to determine whether the driver is exhausted, lacks concentration, or dozes.

The microcomputer 12051 collects the information inside and outside the vehicle which is acquired by the external information detecting unit 12030 and the internal information detecting unit 12040 and processes the thus acquired information to calculate target values for the power generating unit, the steering mechanism, and the braking system and sends control commands to the drive system control unit 12010. For example, the microcomputer 12051 performs cooperative control intended to realize the advanced driver assistance system (ADAS) which includes collision avoidance, shock relaxation, trailing run keeping an adequate vehicular gap, constant speed run, collision alarming, and lane deviation warning.

In addition, the microcomputer 12051 controls the power generating unit, the steering mechanism, and the braking system in response to the information inside and outside the vehicle which is acquired by the external information detecting unit 12030 and the internal information detecting unit 12040, thereby accomplishing cooperative control for automatic driving which obviates the necessity of driver's operation.

Moreover, the microcomputer 12051 issues control commands to the body system control unit 12020 in response to the information outside the vehicle which is acquired by the external information detecting unit 12030. For example, the microcomputer 12051 controls the head lamps, in accordance with the position of the fore-running vehicles or oncoming vehicles detected by the external information detecting unit 12030, to switch between high beam and low beam for glare prevention.

The audio-visual output section 12052 transmits output signals of either or both voice and image to the output device which gives visual or audio information to people inside and outside the vehicle. The output device exemplified in FIG. 17 includes an audio speaker 12061, a display section 12062, and an instrument panel 12063. The display section 12062 includes at least one of the on-board display and the head-up display.

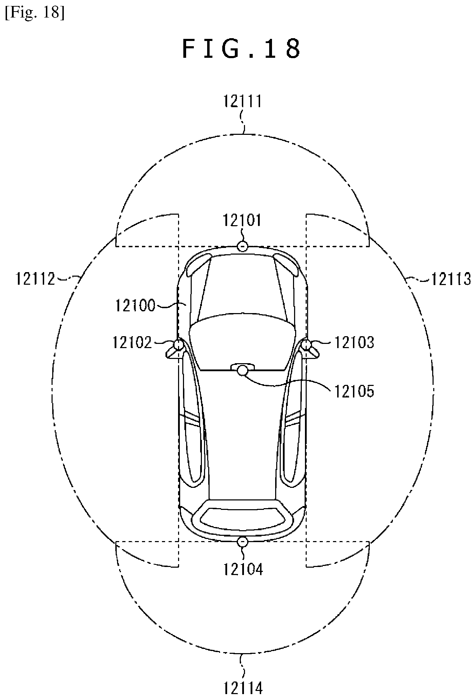

FIG. 18 is a diagram depicting the typical arrangement of the imaging section 12031.

It is assumed that the vehicle 12100 depicted in FIG. 18 has the imaging section 12031 which includes imaging subsections 12101, 12102, 12103, 12104, and 12105.

The imaging subsections 12101, 12102, 12103, 12104, and 12105 are attached to various parts of the vehicle, such as front nose, side mirrors, rear bumper, back door, and front glass (inside top). The imaging subsections 12101 (attached to the front nose) and 12105 (attached to inside top of front glass) acquires images in front of the vehicle 12100. The imaging subsections 12102 and 12103 (attached to the side mirrors) acquire images on both sides of the vehicle 12100. The imaging subsection 12104 (attached to the rear bumper or the back door) acquires images behind the vehicle 12100. The front images taken by the imaging sub-sections 12101 and 12105 are used to detect the fore-running vehicles, pedestrians, obstacles, traffic signals, traffic signs, and lane lines.

The imaging subsections 12101 to 12104 cover the ranges depicted in FIG. 18. A range 12111 is covered by the imaging subsection 12101 attached to the front nose. Ranges 12112 and 12113 are covered respectively by the imaging subsections 12102 and 12103 attached to the side mirrors. A range 12114 is covered by the imaging subsection 12104 attached to the rear bumper or the back door. Images obtained by the imaging subsections 12101 to 12104 are overlapped with one another, so that there is obtained a bird's-eye view seen from above the vehicle 12100.

At least one of the imaging subsections 12101 to 12104 may have a function to acquire the distance information. The one having such a function may be a stereo camera including a plurality of imaging elements or a camera based on an imaging element with pixels for phase difference detection.

The microcomputer 12051 uses the distance information acquired by the imaging subsections 12101 to 12104 to calculate the distance to any three-dimensional objects existing in the coverage ranges of 12111 to 12114, and then it calculates the rate of change of the distance with respect to time (or the velocity relative to the vehicle 12100). In this way, it determines that any three-dimensional object running at a certain speed (for example, 0 km/h or more) in the same direction as the vehicle 12100 is a fore-running vehicle. Moreover, the microcomputer 12051 sets an adequate vehicle gap which is previously reserves and performs automatic braking control (to suspend trailing) and automatic accelerating control (to suspend starting to trail). The foregoing automatic controls achieve the cooperative control for automatic driving which obviates the necessity of the driver's operation.

The microcomputer 12051 uses the distance information acquired by the imaging subsections 12101 to 12104 to recognize any three-dimensional objects as motorcycles, passenger cars, commercial vehicles, pedestrians, poles, etc., so that the vehicle circumvents such obstacles automatically. The microcomputer 12051 recognizes obstacles as those visible and invisible to the driver of the vehicle 12100. The microcomputer 12051 determines whether or not there is the possibility of collision with obstacles, and when there is an apparent possibility, it issues a warning to the driver through the audio speaker 12061 or the display section 12062, or it commands the drive system control unit 12010 to reduce speed or to steer clear of obstacles. In this way, it helps the driver to avoid collisions.

The imaging subsections 12101 to 12104 may include at least one infrared camera, so that the microcomputer 12051 determines whether or not the photographed image includes an image of pedestrians, thereby allowing the driver to recognize the presence of pedestrians. This object is achieved by feature extraction or pattern matching. If the presence of pedestrians is recognized, the audio-visual output section 12052 commands the display section 12062 to display an overlaid square boarder line to emphasize the recognized pedestrians. The audio-visual output section 12052 may also be controlled such that the display section 12062 depicts icons (representing pedestrians) at a prescribed position.

The foregoing has described one example of the vehicle control system to which is applied the technology disclosed herein. The structure mentioned above may be applied to the imaging section 12031. To be more specific, the imaging section 12031 may have the circuit substrate 7, the spacer 10, the fixing section 11, and the CSP solid-state imaging element 20 depicted in FIGS. 1 and 5 to 10. The imaging section 12031 to which is applied the disclosed technology helps the entire system to improve in yields and performance.

### Reference Signs List

1 Solid-state imaging element
2 Glass substrate
4 Infrared cut filter
6 Lens
7 Circuit substrate
8 Actuator
9 Connector
10 Spacer
11, 11-1 to 11-4, 11-21 to 11-24, 11-31, 11-32, 11-41 to 11-43, 11-51, and 11-52 Fixing sections
12 Semiconductor part
13, 13-1 to 13-4, 13-21 to 13-24, 13-31, 13-32, 13-41 to 13-43, 13-51, and 13-52 Fixing agents
31, 32 Adhesive
41 Glass substrate
61 Upper-layer lens
62 Lower-layer lens
91 ACF terminal

## Claims

1. A camera module, comprising:
an imaging device (20), having:
a solid-state image sensor (1), and
a glass substrate (2, 41) bonded to a light-incident side of the solid-state image sensor (1), the solid-state image sensor (1) and the glass substrate (2, 41) together forming an integral body;
a circuit substrate (7) electrically coupled to the solid-state image sensor (1); and
a spacer (10) which fixes a position of the imaging device (20) relative to the circuit substrate (7),
wherein the spacer (10) has a fixing structure (11), the fixing structure (11) having a plurality of first surfaces positioned closer to the imaging device (20) than at least one second surface of the spacer (10), when viewed from a top sectional view intersecting the first and second surfaces, the at least one second surface of the spacer (10) being separated from the imaging device (20) by adhesive, wherein the fixing structure (11) fixes the imaging device (20) at a prescribed position on the circuit substrate (7) when the imaging device (20) is mounted.

2. The camera module device according to claim 1,
wherein the imaging device (20) has a rectangular shape, or
wherein the plurality of first surfaces are positioned adjacent corners and/or sides of the imaging device (20), or
wherein the plurality of first surfaces are positioned adjacent diagonal corners and/or sides of the imaging device (20).

3. The camera module device according to claim 1,
wherein the plurality of first surfaces of the spacer (10) include at least three first surfaces of the spacer (10), in particular,
wherein the at least one second surface of the spacer (10) includes a plurality of second surfaces of the spacer (10).

4. The camera module according to claim 1,
wherein the imaging device (20) further includes an upper-layer lens (61) which constitutes a first part of a lens group which converges the received light.

5. The camera module according to claim 4,
wherein the imaging device (20) further includes a lower-layer lens (62) which is arranged on over the glass substrate (2, 41), the lower-layer lens (62) constituting a second part which is different from the first part and which is arranged on the light-incident side of the solid-state image sensor (1) and in closer proximity to the solid-state image sensor (1) than to the upper-layer lens (61), in particular, further comprising:
an infrared cut filter (4) disposed between the upper-layer lens (61) and the lower-layer lens (62).

6. The camera module according to claim 1,
wherein the imaging device (20) further includes an infrared cut filter (4) to block infrared rays from received light,
the solid-state image sensor (1) and the glass substrate (2) are bonded together with a transparent adhesive (31), and
the glass substrate (2) and the infrared cut filter (4) are bonded together with a transparent adhesive (32).

7. The camera module according to claim 6,
wherein the imaging device (20) further includes an upper-layer lens (61) which constitutes a first part of a lens group which converges the received light, in particular
wherein the imaging device (20) further includes a lower-layer lens (62) which is arranged on the infrared cut filter (4), the lower-layer lens (62) constituting a second part which is different from the first part and which is arranged on the light-incident side of the solid-state image sensor (1) and in closer proximity to the solid-state image sensor (1) than to the upper-layer lens (61).

8. The camera module according to claim 1,
wherein the imaging device (20) further includes an infrared cut filter (4) to block infrared rays from received light, and
the infrared cut filter (4) is arranged between the glass substrate (2) and the solid-state image sensor (1), or
further comprising:
an upper-layer lens (61) including a part of a lens group to converge received light; and
an infrared cut filter (4) to block infrared rays from the received light,
wherein the infrared cut filter (4) is separate from the imaging device (20) and is arranged between the upper-layer lens (61) and the solid-state image sensor (1).

9. The camera module according to claim 1,
wherein the imaging device (20) further includes an upper-layer lens (61) of a lens group to converge received light and a focusing apparatus which converges to a prescribed position light received by the upper-layer lens.

10. The camera module according to claim 9,
wherein the focusing apparatus includes an actuator (8) which drives the upper-layer lens (61) so that the received light is focused on the prescribed position, in particular,
wherein the actuator (8) drives the upper-layer lens (61) to produce either or both of a focusing function and an image stabilizing function.

11. The camera module according to claim 1,
wherein the glass substrate (41) functions as an infrared cut filter, in particular
wherein the glass substrate (41) is a bluish sheet glass,
wherein the imaging device (20) further includes a lower-layer lens (62) which is arranged on over the glass substrate (41), and
wherein the imaging device (20) further includes an upper-layer lens (61) which constitutes a first part of a lens group which converges received light, wherein the lower-layer lens (62) constitutes a second part of the lens group.

12. The camera module according to claim 1,
wherein the circuit substrate (7) further includes a connector (9) or an anisotropic conductive film terminal to output an image signal provided by the solid-state image sensor (1), or
wherein the glass substrate (2) is bonded to the solid-state image sensor (1) above a photoelectric conversion device of the solid-state image sensor (1).

13. The camera module of claim 1, further comprising:
a cavity (121) between the glass substrate (2) and the solid-state image sensor (1), in particular,
wherein the glass substrate (2) includes a frame (2a) at its periphery for mounting the glass substrate (2) on the solid-state image sensor (1) with the cavity (121) therebetween.

14. A method for producing a camera module according to claim 1, the method comprising:
positioning the imaging device at a prescribed position over the circuit substrate using the fixing structure; and
injecting a fixing agent into a gap between the imaging device and the at least one second surface of the spacer.

15. An electronic apparatus comprising:
a camera module according to claim 1.

## Patentansprüche

1. Kameramodul, umfassend:
eine Bildgebungsvorrichtung (20), die folgende Elemente aufweist:
einen Festkörperbildsensor (1) und
ein Glassubstrat (2, 41), das mit einer Lichteinfallsseite des Festkörperbildsensors (1) verbunden ist, wobei der Festkörperbildsensor (1) und das Glassubstrat (2, 41) zusammen einen integralen Körper bilden;
ein Schaltungssubstrat (7), das elektrisch mit dem Festkörperbildsensor (1) gekoppelt ist; und
einen Abstandshalter (10), der eine Position der Bildgebungsvorrichtung (20) relativ zum Schaltungssubstrat (7) fixiert,
wobei der Abstandshalter (10) eine Fixierstruktur (11) aufweist, wobei die Fixierstruktur (11) eine Vielzahl von ersten Flächen aufweist, die näher an der Bildgebungsvorrichtung (20) angeordnet sind als mindestens eine zweite Fläche des Abstandshalters (10), in einer die erste und die zweite Fläche schneidenden Draufsicht betrachtet, wobei die mindestens eine zweite Fläche des Abstandshalters (10) von der Bildgebungsvorrichtung (20) durch Klebstoff getrennt ist, wobei die Fixierstruktur (11) die Bildgebungsvorrichtung (20) an einer vorgegebenen Position auf dem Schaltungssubstrat (7) fixiert, wenn die Bildgebungsvorrichtung (20) montiert wird.

2. Kameramodulvorrichtung nach Anspruch 1,
wobei die Bildgebungsvorrichtung (20) eine rechteckige Form hat, oder
wobei die Vielzahl von ersten Flächen angrenzend an Ecken und/oder Seiten der Bildgebungsvorrichtung (20) angeordnet sind, oder
wobei die Vielzahl von ersten Flächen angrenzend an diagonale Ecken und/oder Seiten der Bildgebungsvorrichtung (20) angeordnet sind.

3. Kameramodulvorrichtung nach Anspruch 1,
wobei die Vielzahl von ersten Flächen des Abstandshalters (10) mindestens drei erste Flächen des Abstandshalters (10) beinhaltet, insbesondere,
wobei die mindestens eine zweite Fläche des Abstandshalters (10) eine Vielzahl von zweiten Flächen des Abstandshalters (10) beinhaltet.

4. Kameramodul nach Anspruch 1,
wobei die Bildgebungsvorrichtung (20) ferner eine Oberschichtlinse (61) beinhaltet, die einen ersten Teil einer Linsengruppe bildet, die das empfangene Licht konvergiert.

5. Kameramodul nach Anspruch 4,
wobei die Bildgebungsvorrichtung (20) ferner eine Unterschichtlinse (62) beinhaltet, die über dem Glassubstrat (2, 41) angeordnet ist, wobei die Unterschichtlinse (62) einen zweiten Teil bildet, der sich vom ersten Teil unterscheidet und der auf der Lichteinfallsseite des Festkörperbildsensors (1) und in größerer Nähe zum Festkörperbildsensor (1) als zur Oberschichtlinse (61) angeordnet ist, insbesondere, ferner umfassend:
einen Infrarotsperrfilter (4), der zwischen der Oberschichtlinse (61) und der Unterschichtlinse (62) eingerichtet ist.

6. Kameramodul nach Anspruch 1,
wobei die Bildgebungsvorrichtung (20) ferner einen Infrarotsperrfilter (4) zum Blockieren von Infrarotstrahlen aus dem empfangenen Licht beinhaltet, der Festkörperbildsensor (1) und das Glassubstrat (2) mit einem transparenten Klebstoff (31) miteinander verbunden sind, und
das Glassubstrat (2) und der Infrarotsperrfilter (4) mit einem transparenten Klebstoff (32) miteinander verbunden sind.

7. Kameramodul nach Anspruch 6,
wobei die Bildgebungsvorrichtung (20) ferner eine Oberschichtlinse (61) beinhaltet, die einen ersten Teil einer Linsengruppe bildet, die das empfangene Licht konvergiert, insbesondere
wobei die Bildgebungsvorrichtung (20) ferner eine Unterschichtlinse (62) beinhaltet, die auf dem Infrarotsperrfilter (4) angeordnet ist, wobei die Unterschichtlinse (62) einen zweiten Teil bildet, der sich vom ersten Teil unterscheidet und der auf der Lichteinfallsseite des Festkörperbildsensors (1) und in größerer Nähe zum Festkörperbildsensor (1) als zur Oberschichtlinse (61) angeordnet ist.

8. Kameramodul nach Anspruch 1,
wobei die Bildgebungsvorrichtung (20) ferner einen Infrarotsperrfilter (4) zum Blockieren von Infrarotstrahlen aus dem empfangenen Licht beinhaltet, und
der Infrarotsperrfilter (4) zwischen dem Glassubstrat (2) und dem Festkörperbildsensor (1) angeordnet ist, oder ferner umfassend:
eine Oberschichtlinse (61), die einen Teil einer Linsengruppe zum Konvergieren von empfangenem Licht beinhaltet; und
einen Infrarotsperrfilter (4) zum Blockieren von Infrarotstrahlen aus dem empfangenen Licht,
wobei der Infrarotsperrfilter (4) von der Bildgebungsvorrichtung (20) getrennt ist und zwischen der Oberschichtlinse (61) und dem Festkörperbildsensor (1) angeordnet ist.

9. Kameramodul nach Anspruch 1,
wobei die Bildgebungsvorrichtung (20) ferner eine Oberschichtlinse (61) einer Linsengruppe zum Konvergieren von empfangenem Licht und eine Fokussiervorrichtung beinhaltet, die von der Oberschichtlinse empfangenes Licht auf eine vorgegebene Position konvergiert.

10. Kameramodul nach Anspruch 9,
wobei die Fokussiervorrichtung einen Aktuator (8) beinhaltet, der die Oberschichtlinse (61) so antreibt, dass das empfangene Licht auf die vorgegebene Position fokussiert wird, insbesondere,
wobei der Aktuator (8) die Oberschichtlinse (61) dazu antreibt, eines oder beides von einer Fokussierungsfunktion und einer Bildstabilisierungsfunktion zu erzeugen.

11. Kameramodul nach Anspruch 1,
wobei das Glassubstrat (41) als ein Infrarotsperrfilter wirkt, insbesondere
wobei das Glassubstrat (41) ein bläuliches Flachglas ist, wobei die Bildgebungsvorrichtung (20) ferner eine Unterschichtlinse (62) beinhaltet, die auf dem Glassubstrat (41) angeordnet ist, und
wobei die Bildgebungsvorrichtung (20) ferner eine Oberschichtlinse (61) beinhaltet, die einen ersten Teil einer Linsengruppe bildet, die empfangenes Licht konvergiert, wobei die Unterschichtlinse (62) einen zweiten Teil der Linsengruppe bildet.

12. Kameramodul nach Anspruch 1,
wobei das Schaltungssubstrat (7) ferner einen Anschluss (9) oder einen Kontakt für einen anisotropen leitfähigen Film beinhaltet, zu dem Zweck, ein vom Festkörperbildsensor (1) bereitgestelltes Bildsignal auszugeben, oder
wobei das Glassubstrat (2) mit dem Festkörperbildsensor (1) oberhalb einer photoelektrischen Umwandlungsvorrichtung des Festkörperbildsensors (1) verbunden ist.

13. Kameramodul nach Anspruch 1, ferner umfassend:
einen Hohlraum (121) zwischen dem Glassubstrat (2) und
dem Festkörperbildsensor (1), insbesondere wobei das Glassubstrat (2) an seinem Umfang einen Rahmen (2a) zur Montage des Glassubstrats (2) auf dem Festkörperbildsensor (1) mit dem dazwischen liegenden Hohlraum (121) beinhaltet.

14. Verfahren zur Herstellung eines Kameramoduls nach Anspruch 1, wobei das Verfahren umfasst:
Anordnen der Bildgebungsvorrichtung an einer vorgegebenen Position über dem Schaltungssubstrat unter Verwendung der Fixierstruktur; und
Injizieren eines Fixiermittels in einen Spalt zwischen der Bildgebungsvorrichtung und der mindestens einen zweiten Fläche des Abstandshalters.

15. Elektronische Vorrichtung, umfassend:
ein Kameramodul nach Anspruch 1.

## Revendications

1. Module de caméra, comportant :
un dispositif (20) d'imagerie, comprenant :
un capteur (1) d'image à semi-conducteurs, et
un substrat (2, 41) en verre collé à un côté d'incidence de lumière du capteur (1) d'image à semi-conducteurs, le capteur (1) d'image à semi-conducteurs et le substrat (2, 41) en verre formant ensemble un corps intégré ;
un substrat (7) de circuit couplé électriquement au capteur (1) d'image à semi-conducteurs ; et
une entretoise (10) qui fixe une position du dispositif (20) d'imagerie par rapport au substrat (7) de circuit, l'entretoise (10) comprenant une structure (11) de fixation, la structure (11) de fixation comprenant une pluralité de premières surfaces positionnées plus près du dispositif (20) d'imagerie qu'au moins une seconde surface de l'entretoise (10), dans une vue de dessus en coupe croisant les premières et secondes surfaces, la ou les secondes surfaces de l'entretoise (10) étant séparées du dispositif (20) d'imagerie par de l'adhésif, la structure (11) de fixation fixant le dispositif (20) d'imagerie dans une position prescrite sur le substrat (7) de circuit lorsque le dispositif (20) d'imagerie est monté.

2. Dispositif de module de caméra selon la revendication 1,
le dispositif (20) d'imagerie présentant une forme rectangulaire, ou
la pluralité de premières surfaces étant positionnée de manière adjacente à des coins et/ou à des côtés du dispositif (20) d'imagerie, ou
la pluralité de premières surfaces étant positionnée de manière adjacente à des coins diagonaux et/ ou à des côtés du dispositif (20) d'imagerie.

3. Dispositif de module de caméra selon la revendication 1,
la pluralité de premières surfaces de l'entretoise (10) comprenant au moins trois premières surfaces de l'entretoise (10), en particulier,
la ou les secondes surfaces de l'entretoise (10) comprenant une pluralité de secondes surfaces de l'entretoise (10).

4. Module de caméra selon la revendication 1,
le dispositif (20) d'imagerie comprenant en outre une lentille (61) de couche supérieure qui constitue une première partie d'un groupe de lentilles qui fait converger la lumière reçue.

5. Module de caméra selon la revendication 4,
le dispositif (20) d'imagerie comprenant en outre une lentille (62) de couche inférieure qui est disposée par-dessus le substrat (2, 41) en verre, la lentille (62) de couche inférieure constituant une seconde partie qui est différente de la première partie et qui est disposée du côté d'incidence de lumière du capteur (1) d'image à semi-conducteurs et à proximité plus immédiate du capteur (1) d'image à semi-conducteurs que de la lentille (61) de couche supérieure, en particulier comportant en outre :
un filtre (4) de coupure d'infrarouges disposé entre la lentille (61) de couche supérieure et la lentille (62) de couche inférieure.

6. Module de caméra selon la revendication 1,
le dispositif (20) d'imagerie comprenant en outre un filtre (4) de coupure d'infrarouges servant à bloquer des rayons infrarouges provenant d'une lumière reçue,
le capteur (1) d'image à semi-conducteurs et le substrat (2) en verre étant collés ensemble à l'aide d'un adhésif transparent (31), et
le substrat (2) en verre et le filtre (4) de coupure d'infrarouges étant collés ensemble à l'aide d'un adhésif transparent (32).

7. Module de caméra selon la revendication 6,
le dispositif (20) d'imagerie comprenant en outre une lentille (61) de couche supérieure qui constitue une première partie d'un groupe de lentilles qui fait converger la lumière reçue, en particulier le dispositif (20) d'imagerie comprenant en outre une lentille (62) de couche inférieure qui est disposée sur le filtre (4) de coupure d'infrarouges, la lentille (62) de couche inférieure constituant une seconde partie qui est différente de la première partie et qui est disposée du côté d'incidence de lumière du capteur (1) d'image à semi-conducteurs et à proximité plus immédiate du capteur (1) d'image à semi-conducteurs que de la lentille (61) de couche supérieure.

8. Module de caméra selon la revendication 1,
le dispositif (20) d'imagerie comprenant en outre un filtre (4) de coupure d'infrarouges servant à bloquer des rayons infrarouges provenant d'une lumière reçue, et
le filtre (4) de coupure d'infrarouges étant disposé entre le substrat (2) en verre et le capteur (1) d'image à semi-conducteurs, ou
comportant en outre :
une lentille (61) de couche supérieure comprenant une partie d'un groupe de lentilles servant à faire converger une lumière reçue ; et
un filtre (4) de coupure d'infrarouges servant à bloquer des rayons infrarouges provenant de la lumière reçue,
le filtre (4) de coupure d'infrarouges étant distinct du dispositif (20) d'imagerie et étant disposé entre la lentille (61) de couche supérieure et le capteur (1) d'image à semi-conducteurs.

9. Module de caméra selon la revendication 1,
le dispositif (20) d'imagerie comprenant en outre une lentille (61) de couche supérieure d'un groupe de lentilles servant à faire converger une lumière reçue et un appareil de focalisation qui fait converger vers une position prescrite une lumière reçue par la lentille de couche supérieure.

10. Module de caméra selon la revendication 9,
l'appareil de focalisation comprenant un actionneur (8) qui entraîne la lentille (61) de couche supérieure de telle sorte que la lumière reçue soit focalisée sur la position prescrite, en particulier,
l'actionneur (8) entraînant la lentille (61) de couche supérieure pour produire une fonction de focalisation et/ou une fonction de stabilisation d'image.

11. Module de caméra selon la revendication 1,
le substrat (41) en verre fonctionnant comme un filtre de coupure d'infrarouges, en particulier le substrat (41) en verre étant une vitre bleutée,
le dispositif (20) d'imagerie comprenant en outre une lentille (62) de couche inférieure qui est disposée par-dessus le substrat (41) en verre, et
le dispositif (20) d'imagerie comprenant en outre une lentille (61) de couche supérieure qui constitue une première partie d'un groupe de lentilles qui fait converger une lumière reçue, la lentille (62) de couche inférieure constituant une seconde partie du groupe de lentilles.

12. Module de caméra selon la revendication 1,
le substrat (7) de circuit comprenant en outre un connecteur (9) ou une borne de film conducteur anisotrope pour délivrer un signal d'image fourni par le capteur (1) d'image à semi-conducteurs, ou
le substrat (2) en verre étant collé au capteur (1) d'image à semi-conducteurs au-dessus d'un dispositif de conversion photoélectrique du capteur (1) d'image à semi-conducteurs.

13. Module de caméra selon la revendication 1, comportant en outre :
une cavité (121) entre le substrat (2) en verre et le capteur (1) d'image à semi-conducteurs, en particulier le substrat (2) en verre comprenant un cadre (2a) à sa périphérie pour monter le substrat (2) en verre sur le capteur (1) d'image à semi-conducteurs, la cavité (121) se trouvant entre ceux-ci.

14. Procédé de production d'un module de caméra selon la revendication 1, le procédé comportant les étapes consistant à :
positionner le dispositif d'imagerie dans une position prescrite au-dessus du substrat de circuit à l'aide de la structure de fixation ; et
injecter un agent de fixation dans un écartement entre le dispositif d'imagerie et la ou les secondes surfaces de l'entretoise.

15. Appareil électronique comportant :
un module de caméra selon la revendication 1.
